(19) Europäisches Patentamt
European Patent Office
Office européen des brevets

(11) **EP 2 228 901 B1**

(12) **EUROPÄISCHE PATENTSCHRIFT**

(45) Veröffentlichungstag und Bekanntmachung des Hinweises auf die Patenterteilung:
**23.10.2013 Patentblatt 2013/43**

(51) Int Cl.:
*H03F 3/42* *(2006.01)*    *H03F 3/189* *(2006.01)*

(21) Anmeldenummer: **10002697.0**

(22) Anmeldetag: **15.03.2010**

(54) **Hybrid-Verstärkerelement sowie Schaltungsanordnung**

Hybrid amplifier element and switching assembly

Elément de renforcement hybride ainsi qu'agencement de commutation

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **14.03.2009 DE 102009013236**

(43) Veröffentlichungstag der Anmeldung:
**15.09.2010 Patentblatt 2010/37**

(73) Patentinhaber: **Kemna, Philipp**
**90763 Fürth (DE)**

(72) Erfinder: **Kemna, Philipp**
**90763 Fürth (DE)**

(74) Vertreter: **FDST Patentanwälte**
**Nordostpark 16**
**90411 Nürnberg (DE)**

(56) Entgegenhaltungen:
**DE-A1- 10 114 935      DE-A1-102004 056 435**
**DE-C1- 19 600 593      US-A- 5 070 538**

- **REYNOLDS S ET AL: "A high-voltage, high-frequency linear amplifier/driver for capacitive loads" MEASUREMENT SCIENCE AND TECHNOLOGY, IOP, BRISTOL, GB LNKD- DOI: 10.1088/0957-0233/3/3/005, Bd. 3, Nr. 3, 1. März 1992 (1992-03-01), Seiten 283-288, XP020065204 ISSN: 0957-0233**

## Beschreibung

Die Erfindung betrifft ein Hybrid-Verstärkerelement mit einem Verstärkerelement und mit einer dem Verstärkerelement zugeordneten Entkoppeleinheit. Die Erfindung betrifft weiter eine Schaltungsanordnung mit einer Serienschaltung der Hybrid-Verstärkerelemente.

Die Erfindung beschäftigt sich mit dem Problem, eine lineare Spannungsaufteilung zwischen seriengeschalteten Verstärkerelementen bei Spannungen im Bereich von einigen 100 Volt bis vielfache 1.000 Volt insbesondere auch für hohe Frequenzen zu gewährleisten. Eine solche Serienschaltung wird beispielsweise für lineare Hochspannungsverstärker und Netzteile benötigt.

Verstärkerelemente, wie ein Transistor oder eine Röhre weisen eine zulässige Durchbruchspannung des Leistungspfades, also zwischen Kollektor und Emitter bei bipolaren Transistoren und IGBT Transistoren, zwischen Drain und Source bei Feldeffekttransistoren und zwischen Anode und Kathode bei einer Triode, auf. Sollen mit einem Verstärkerelement größere Spannungen verarbeitet werden, ist daher eine Serienschaltung von Verstärkerelementen unumgänglich. Ähnlich wie bei einer Serienschaltung von ohmschen Widerständen, findet dabei eine Spannungsteilung unter den einzelnen Leistungspfaden der Verstärkerelemente der Serienschaltung statt, so dass in der Summe Spannungsamplituden oberhalb der einzelnen Durchbruchspannung ermöglicht werden.

Ein gundsätzliches Problem einer Serienschaltung von Verstärkerelementen liegt in der gleichzeitigen Zuführung der Steuerspannungen zu den einzelnen Verstärkerelementen der Serienschaltung, die sich nicht wie bei einer Parallelschaltung auf ein gemeinsames Bezugspotential abstützen können, sondern um variable, große Potentialdifferenzen auseinander liegen, die sich zudem bei höheren Frequenzen entsprechend schnell ändern.

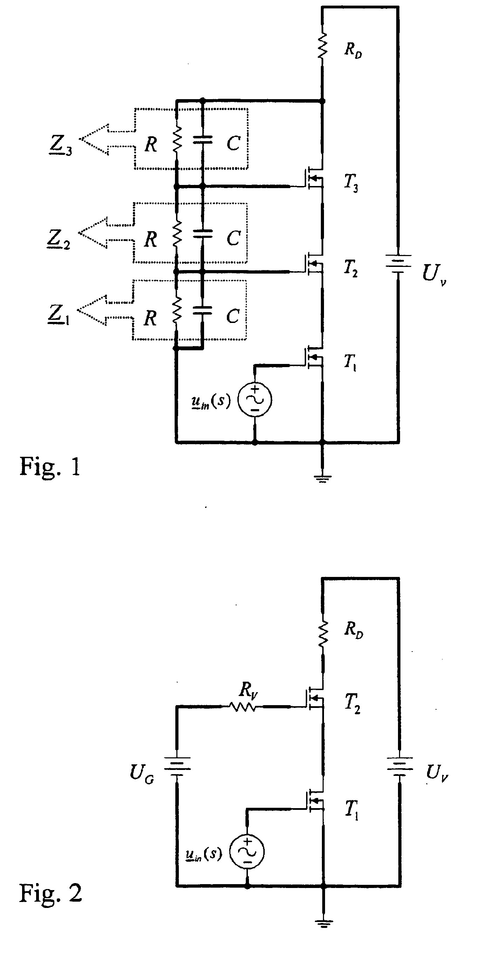

In der DE 196 00 593 C1 wird für die Zuführung der Steuerspannungen an die Steuereingänge der einzelnen Verstärkerelemente, die hier MOSFET-Transistoren sind, jeweils ein Optokoppler verwendet. Optokoppler ermöglichen zwar die erforderliche Potentialtrennung, weisen aber nachteiligerweise eine nicht zu vernachlässigende Übergangskapazität auf, so dass bei hohen Frequenzen ein unerwünschtes Übersprechen der einzelnen Verstärkerelemente auf das Bezugspotential der Steuerschaltung stattfindet. Aufgrund der Verzögerungen in dem optischen Empfangstransistor entstehen Phasenverschiebungen, die sich zu denen der Verstärkerelemente addieren und die mögliche Schleifenverstärkung für eine wirksame Regelung des Ausgangssignals der seriengeschalteten Verstärkerelemente reduziert. Der Arbeitspunkt für jeden MOSFET-Transistor muss bei diesem Verfahren einzeln eingestellt werden und bei vielen seriengeschalteten Verstärkerelementen werden deren Fertigungstoleranzen der Zwischenelektrodenkapazitäten nur unzureichend ausgeglichen, so dass eine gleichmäßige Spannungsaufteilung nicht gewährleistet ist. Es ist daher wünschenswert, eine Serienschaltung von Verstärkerelementen ohne Optokoppler und einzelne Arbeitspunktjustage jedes Verstärkerelement zu realisieren. Aus dem Buch "Die hohe Schule der Elektronik", P. Horrowitz, W. Hill, Elektorverlag 2001 wird auf S. 418 (Abb. 652) eine Serienschaltung von Transistoren mit diesen Merkmalen gezeigt. Betrachtet wird die dort abgebildete MOSFET-Alternative, die vorliegend in Fig. 1 dargestellt ist. Gemäß der PCT/US 87/02622 wird diese Schaltung mit MOSFET-Transistoren benutzt; entsprechend der DE 101 14 935 A1 sind die MOSFET durch D-MOSFET ersetzt.

Die Erfindung hat sich die Aufgabe gestellt, eine Serienschaltung von Verstärkerelementen mit erhöhter Durchbruchspannung in den kV-Bereich hinein zu verbessern. Insbesondere sollen die Bandbreite, die Linearität, die Zuverlässigkeit und der Wirkungsgrad verbessert werden.

Diese Aufgabe wird erfindungsgemäß durch die Bereitstellung eines Hybrid-Verstärkerelements mit der Merkmalskombination gemäß Anspruch 1 gelöst.

Demnach weist das Hybrid-Verstärkerelement ein Verstärkerelement, umfassend einen Steuereingang und einen Leistungspfad, eine Entkoppeleinheit, die einen Puffereingang, einen Pufferausgang, einen Referenzanschluss und einen Stromregelanschluss umfasst, und einen am Puffereingang angeschlossenen Spannungsteiler auf, der parallel zum Leistungspfad geschaltet ist, auf, wobei der Pufferausgang an den Steuereingang des Verstärkerelements geschaltet und der Leistungspfad des Verstärkerelements über den Stromregelanschluss und den Referenzanschluss geführt ist. Dabei bildet der Referenzanschluss für die weiteren Anschlüsse ein Bezugspotential, wobei der Puffereingang gegenüber dem Referenzanschluss eine hochohmige Eingangsimpedanz aufweist, wobei der Pufferausgang gegenüber dem Referenzanschluss eine niederohmige Ausgangsimpedanz aufweist, wobei eine Einrichtung zur linearen Spannungsverstärkung zwischen dem Puffereingang und dem Pufferausgang und/oder eine Einrichtung zur Erzeugung einer Referenzspannung zwischen dem Pufferausgang und dem Referenzanschluss und eine Einrichtung zur Beeinflussung des Stromes zwischen dem Stromregelanschluss und dem Referenzanschluss in Abhängigkeit von der Spannung zwischen dem Puffereingang und dem Referenzanschluss vorgesehen sind.

Die Erfindung geht dabei von dem Gedanken aus, durch eine dem Verstärkerelement zugeschaltete Entkoppeleinheit ein Hybrid-Verstärkerelement zu schaffen, welches die durch die realen Eigenschaften des Verstärkerelements als solchem resultierenden Nachteile in einer Serienschaltung von Verstärkerelementen vermeidet.

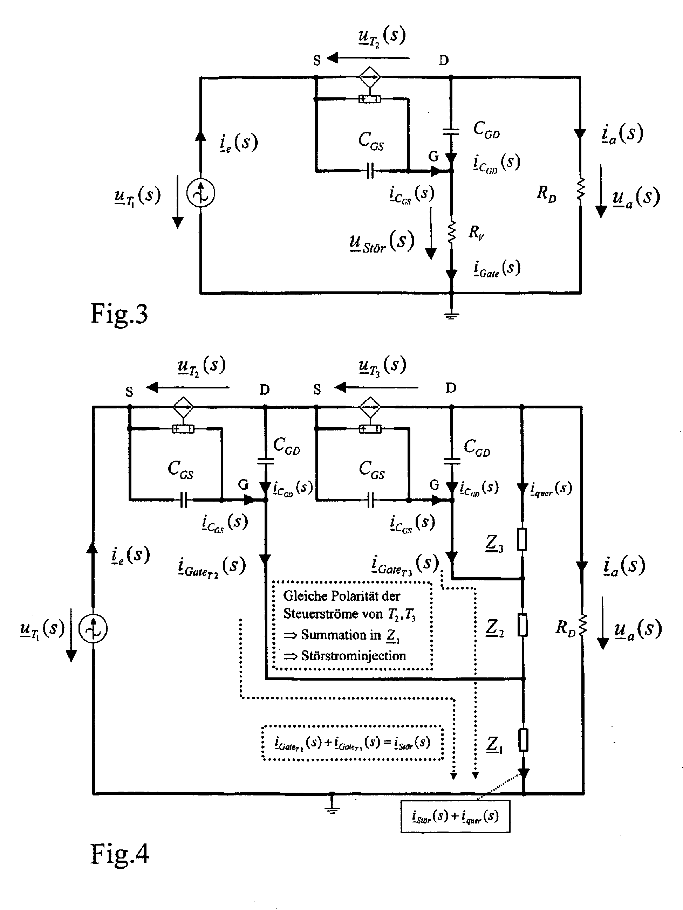

Dazu betrachtet die Erfindung zunächst eine Gate-Schaltung eines MOSFET mit Stromansteuerung, wie sie z.B. aus dem Buch "Halbleiterschaltungstechnik", U.Tietze, Ch. Schenk, Springer Verlag, 12. Auflage 2002 auf S. 268 ff. analysiert ist. Eine entsprechende Schaltung ist vorliegend in Fig. 2 abgebildet. Das entsprechende Kleinsignalersatzschaltbild kann in vereinfachter Form Fig. 3 entnommen werden.

Der Transistor T1 wird als eine ideale Stromquelle modelliert. Der Transistor T2 wirkt als eine spannungsgesteuerte Stromquelle. Die über dem Widerstand $R_D$ abfallende Spannung ist die Ausgangsspannung $\underline{u}_a(s)$. Für den Frequenzgang der Transimpedanz gilt:

$$\underline{Z}_T(s) = \frac{\underline{u}_o(s)}{\underline{i}_a(s)} \approx \frac{R_D}{1 + s \cdot (\frac{C_{GS}}{S} + C_{GD} \cdot R_D)}$$

mit der Grenzfrequenz von $\underline{Z}_T(s)$:

$$\omega_{-3dB} = 2\pi \cdot f_{-3dB} \approx \frac{1}{\frac{C_{GS}}{S} + C_{GD} \cdot R_D}$$

$C_{GS}$ ist dabei die Gate- Source Kapazität, $C_{GD}$ die Gate- Drain Kapazität, $S$ ist die Steilheit des MOSFET, $\underline{i}_e(s)$ ist der Strom der Eingangsstromquelle, $\underline{u}_a(s)$ die über dem Lastwiderstand $R_D$ abfallende Ausgangsspannung.

Der Transistor $T_2$ reicht den Strom der Eingangsstromquelle $\underline{i}_e(s)$ im Idealfall als $\underline{i}_a(s)$ unverändert weiter, so dass an dem Drainwiderstand $R_D$ die Ausgangsspannung $\underline{u}_a(s) = \underline{i}_e(s)$. $R_D$ abfällt. Mit steigender Frequenz f des Eingangsstromes $\underline{i}_e(s)$ führen die Kapazitäten $C_{GS}$ und $C_{GD}$ von $T_2$ jedoch die beiden Anteile des Steuerstromes $i_{CGD}$ und $i_{CGS}$ als Summenstrom $\underline{i}_{Gate}$ an dem Drainwiderstand $R_D$ vorbei. Die Steuerströme $i_{CGD}$ und $i_{CGS}$ summieren sich bei einem Verstärkerelement stets, was die Grundlage für den bekannten Miller Effekt ist. Deshalb sinkt die Ausgangsspannung mit steigender Frequenz, auch wenn die Eingangsstromquelle $\underline{i}_e(s)$ als ideal angenommen wird. Der Gatewiderstand $R_v$ führt mit steigender Frequenz mehr Strom, da der Strom $\underline{i}_{Gate}$ steigt. Der resultierende Spannungsabfall $\underline{u}_{Stör}$ an $R_v$ würde sofort die wirksame Steuerspannung $\underline{u}_{GS}$ am Transistor $T_2$ reduzieren, falls die Eingangsstromquelle durch eine Spannungsquelle ersetzt wäre. Die Eingangsstromquelle überwindet jedoch den Spannungsabfall $\underline{u}_{Stör}$ am Widerstand $R_v$, indem sie ihre Klemmenspannung $\underline{u}_{TI}(s)$ erhöht, bis der durch die Eingangsstromquelle programmierte Eingangsstrom $\underline{i}_e(s)$ fließt. Dies hat mit steigender Frequenz des Eingangsstrom $\underline{i}_e(s)$ eine steigende Amplitude der Klemmenspannung $\underline{u}_{TI}(s)$ der Eingangsstromquelle zur Folge.

Zur weiteren Erläuterung der Erfindung zeigt die vorliegende Fig. 4 das vereinfachte Kleinsignalersatzschaltbild der aus dem Stand der Technik bekannten Serienschaltung gemäß Fig. 1. Wie ein Vergleich mit der Schaltung gemäß Fig. 3 zeigt, handelt es sich um eine stromgesteuerte Gate-Schaltung, wie sie gerade beschrieben wurde. Die Eingangsstromquelle reicht den Eingangsstrom $\underline{i}_e(s)$ nun jedoch nicht nur über einen Transistor, also eine spannungsgesteuerte Stromquelle, an den Lastwiderstand $R_D$ weiter, sondern durch zwei Transistoren $T_2$ und $T_3$. Im allgemeinen Fall durch n weitere Transistoren. Die Motivation der Schaltung ist es nun, die Klemmenspannungen der seriengeschalteten, spannungsgesteuerten Stromquellen $\underline{u}_{T2}(s)$ und $\underline{u}_{T3}(s)$ im allgemeinen Fall n spannungsgesteuerter Stromquellen, sowie die Klemmenspannung der Eingangsstromquelle $\underline{u}_{TI}(s)$ über den gesamten Frequenzbereich der Schaltung gleich zu halten. Auf diese Weise können dann Spannungen verarbeitet werden, die um $n + 1$ größer sind, als die zulässige Klemmenspannung einer einzelnen spannungsgesteuerten Stromquelle bzw. eines einzelnen Verstärkerelements oder Transistors, falls alle Verstärkerelemente gleiche Durchbruchspannung aufweisen. Die Spannungsteilerkette $\underline{Z}_1, \underline{Z}_2, \underline{Z}_3$ soll die Potentiale an den Steuereingängen der Transistoren für den Arbeitspunkt und für eine Wechselstrom-Aussteuerung äquidistant halten. Sie liegt parallel zu dem Lastwiderstand $R_D$ und führt deshalb einen Teil des Eingangsstromes $\underline{i}_e(s)$ an der Last vorbei, was unerwünscht ist. Besteht die Spannungsteilerkette $\underline{Z}_1, \underline{Z}_2, \underline{Z}_3$ aus ohmschen Widerständen, geschieht dies zunächst frequenzunabhängig. Entscheidenden Einfluss nehmen nun aber die Steuerströme der beiden seriengeschalteten Transistoren $T_2$ und $T_3$, indem über ihre Gate-Elektroden mit steigender Frequenz steigende Steuerströme $\underline{i}_{Gatae2}(s)$ und $\underline{i}_{Gate3}(s)$ in die jeweiligen Potentialabgriffe der Spannungsteilerkette eingespeist oder entnommen werden. Jedes der seriengeschalteten Verstärkerelemente oder Transistoren wird von dem "darunter" liegenden Verstärkerelement stromgesteuert und führt einen Teil des Eingangsstromes $\underline{i}_e(s)$ über die Spannungsteilerkette als Steuerstrom an dem Drainwiderstand $R_D$ vorbei. Die Steuerströme weisen hierbei eine geringe Phasenverschiebung untereinander auf.

Die Erfindung erkennt nun weiter, dass die Steuerströme $\underline{i}_{Gate2}(s)$ und $\underline{i}_{Gate3}(s)$ gleiches Vorzeichen besitzen. Ist dies nicht der Fall, so arbeiten die seriengeschalteten Verstärkerelemente oder Transistoren gegeneinander, was die Verstärkerschaltung offensichtlich unbrauchbar machen würde. Dies kann bei vielen seriengeschalteten Verstärkerelementen oder Transistoren passieren, wenn die erwähnte Phasenverschiebung der Steuerströme von der untersten Stufe zu weit oben liegenden Stufen 180° erreicht. Insbesondere bedeutet die gleiche Steuerstrompolarität der seriengeschalteten Transistoren, dass nicht der Steuerstrom einer Stufe von der über ihr liegenden geliefert werden kann. Auch für den praxisfernen Fall, dass alle seriengeschalteten Transistoren gleiche Zwischenelektrodenkapazitäten zeigen, ist die Potentialverteilung der Spannungsteilerkette $\underline{Z}_1, \underline{Z}_2$ und $\underline{Z}_3$ nicht äquidistant, weil jede Spannungsteilerimpedanz einen unterschiedlichen Strom führt. In der untersten Spannungsteilerimpedanz $\underline{Z}_1$ sammeln sich die Steuerströme $\underline{i}_{Gate2}(s)$ und $\underline{i}_{Gate3}(s)$. Diese Summe wird vorliegend als Störstrominjektion $\underline{i}_{Stör}(s)$ bezeichnet.

Die Erfindung erkennt nun in einem zusätzlichen Schritt, dass die Steuerströme $\underline{i}_{Gate2}(s)$ und $\underline{i}_{Gate3}(s)$ nicht linear sind, weil die einzelnen Steuerströme von nicht linearen Größen $C_{GS}$, $C_{GD}$ und der Steilheit S der Verstärkerelemente bzw. Transistoren verursacht werden. Aus diesem Grund ist auch die Störstrominjektion $\underline{i}_{Stör}(s)$ nicht linear. Auch wenn der Eingangsstrom $\underline{i}_e(s)$ verzerrungsfrei ist, weist der Ausgangsstrom $\underline{i}_{out}(s)$ deshalb einen nicht zu vernachlässigenden Klirrfaktor auf.

Eine gleichmäßige Spannungsaufteilung auf die seriengeschalteten Verstärkerelemente oder Transistoren kann mit der bekannten Serienschaltung nur dann erreicht werden, wenn der Querstrom $\underline{i}_{quer}(s)$ durch die Spannungsteilerkette groß im Vergleich zu der Störstrominjektion $\underline{i}_{Stör}(s)$ ist. Das lässt sich nur mit einem niederohmigen Spannungsteiler erreichen. Hiermit sind jedoch hohe Wärmeverluste je Spannungsteilerwiderstand verbunden, weil bei Spannungen im $kV$ - Bereich wegen der quadratischen Spannungsabhängigkeit des Wärmeverlustes an einem Widerstand

$$P_{Verlust} = \frac{U^2}{R}$$

bereits 1 $M\Omega$ bei 1 kV-Spannungsabfall 1 W in Wärme umsetzt. Bei 2kV Spannungsabfall werden dementsprechend bereits 4$W$ in Wärme umgesetzt. Alternativ können Kondensatoren parallel zu den Spannungsteilerwiderständen geschaltet werden, was zu einer gewünschten kleinen Impedanz bei hohen Frequenzen führt, gleichzeitig aber die Bandbreite einschränkt.

In dem eingangs erwähnten Buch "Die hohe Schule der Elektronik", P. Horowitz, W. Hill, Elektor Verlag 2001 wird auf S. 417 die vorbeschriebene Serienschaltung von Verstärkerelementen kommentiert. Dabei wird empfohlen, kleine Kondensatoren parallel zu den Teilerwiderständen zu legen, um auf diese Weise die Teilerfunktion bei hohen Frequenzen aufrecht zu erhalten. Der Kondensatorwert soll empfehlungsgemäß genügend groß sein, um Unterschiede in der Eingangsimpedanz der Transistoren auszugleichen, die sonst eine ungleiche Teilung hervorrufen und damit die gesamte Durchschlagsspannung herabsetzten würden.

Nach Überlegung der Erfindung lässt sich diese Auffassung jedoch nicht aufrecht erhalten. Der Kondensatorwert muss nicht genügend groß sein, um Unterschiede in der Eingangsimpedanz der Transistoren auszugleichen. Auch bei identischer Eingangsimpedanz der Transistoren ist die Spannungsaufteilung nicht gleichmäßig, weil sich die Steuereingänge der Transistoren oder Verstärkerelemente wegen der Stromsteuerung durch die vorhergehende Stufe jeder wie ein Stromzu-oder -abfluss verhalten. Die Steuereingänge verhalten sich dadurch in der Summe wie eine Störstromquelle. Die Steuerstrompolarität ist dabei für alle Steuereingänge gleich. Jede Teilerimpedanz führt deshalb einen verschiedenen Strom mit steigendem Wert, je näher die Teilerimpedanz zu der Eingangsstromquelle liegt. Schließlich addieren sich die Steuerströme insgesamt in dem ersten Spannungsteilerwiderstand, hier $\underline{Z}_1$. Die Kondensatoren C (siehe Fig. 1) müssen so groß gemacht werden, dass der Querstrom durch die Spannungsteilerkette, also der Strom ohne Störstrominjektion, groß gegenüber dieser Summe der Steuerströme wird, also wesentlich größer als Unterschiede in der Eingangsimpedanz der Transistoren. Das bedeutet auch, dass die Kondensatoren bei mehr seriengeschalteten Transistoren ebenfalls größer werden müssen, weil die Störstrominjektion größer wird. Der eingangs gezeigte Zusammenhang einer steigenden Klemmenspannung der Eingangsstromquelle mit steigender Frequenz bewirkt, übertragen auf eine erweiterte Gate-Schaltung mit Stromsteuerung, dass die Spannung über der Eingangsstromquelle in einer solchen Serienschaltung von Transistoren oder Verstärkerelementen bei hohen Frequenzen die größte Amplitude aufweist und der am weitesten von der Eingangsstromquelle entfernt liegende Transistor die kleinste Amplitude. Dies kann zu einem Durchschlag eines weiter unten liegenden Transistors führen und in der Folge successiv zu dem der ganzen Kette.

Durch das angegebene Hybrid-Verstärkerelement wird die gestellte Aufgabe dadurch gelöst, dass eine Spannungsteilerkette $\underline{Z}_1, \underline{Z}_2$ und $\underline{Z}_3$ oder ganz allgemein ein Netzwerk zur Potentialaufteilung von belastenden, parasitären Strömen weitgehend befreit wird, indem diese Ströme über kleine Impedanzen auf den Hauptstrompfad bzw. in den Leistungspfad der in Serie geschalteten Verstärkerelemente zurückgeführt werden. Der Strom zu den Steuereingängen der Verstärkerelemente fließt deshalb an der Spannungsteilerkette vorbei, so dass diese mit kleinen parallelen Kondensatoren ,vorzugsweise $C \leq 100pF$, breitbandig auf gleiches Teilerverhältnis gebracht werden kann. Die Steuerströme werden über die kleine Impedanz des Pufferausgangs der Entkopplungseinheit je Verstärkerelement lokal umgeladen Dabei geht die Erfindung von der dargestellten Überlegung aus, dass es die Steuerströme zwischen den Abgriffen der Spannungsteiler und den Steuereingängen der Verstärkerelemente sind, die für niedrige obere Grenzfrequenz , hohen Klirrfaktor und hohe Verlustwärme ursächlich sind.

Die Entkoppeleinheit des Hybrid-Verstärkerelements ist hierzu derart konzipiert, dass alle Anschlusspotentiale gegenüber dem Potential des Referenzanschlusses definiert sind. Das Potential des Referenzanschlusses stellt somit für die gesamte Entkoppeleinheit das Referenz- oder Bezugspotential dar. Der Puffereingang und der Pufferausgang der Entkoppeleinheit sind in den Steuerpfad des entsprechenden Verstärkerelements geschaltet. Über den Puffereingang ist das angegebene Hybrid-Verstärkerelement mit einem parallel zum Leistungspfad geschalteten Spannungsteiler verbunden. Dieser Spannungsteiler ist bei Verwendung des Hybrid-Verstärkerelements in einer Serienschaltung zu einer notwendigen Spannungsaufteilung für die einzelnen Verstärkerelemente vorgesehen. Durch die hohe Eingangsimpedanz des Puffereinganges gegenüber dem Referenzanschluss und die niedrige Ausgangsimpedanz des Pufferausganges gegenüber dem Referenzanschluss wird sichergestellt, dass die Ladungsbewegung des Puffereinganges gegenüber der am Pufferausgang stark gedämpft wird. Dazu sollte der Betrag der komplexwertigen Eingangsimpedanz $|\underline{Z}in|$ insbesondere bis zu der gewünschten oberen Eingangssignalfrequenz $f_{Grenz}$ groß gegenüber dem Betrag einer Spannungsteilerimpedanz $|\underline{Z}|$ sein, also $|\underline{Z}_{in}|_{f_{Grenz}} \geq 10 \cdot \underline{Z}_{in}|_{f_{Grenz}}$. Typischerweise ist die Eingangsimpedanz größer als 1 $M\Omega$ zu fordern. Die Ausgangsimpedanz wird klein gegenüber der Impedanz des Steuereinganges eines Verstärkerelementes gewählt und liegt beispielsweise im Ohm-Bereich. Idealerweise geht die Eingangsimpedanz gegen unendlich, die Ausgangsimpedanz gegen Null. Auf diese Weise wird durch die Entkoppeleinheit verhindert, dass über den Steueranschluss des Verstärkerelementes ein Störstrom in die Spannungsteilerkette injiziert wird.

Die Entkoppeleinheit beeinflusst weiter die wirksame Steilheit des Hybrid-Verstärkerelementes in gewünschter Weise. Hierzu ist eine Einrichtung zur linearen Spannungsverstärkung zwischen dem Puffereingang und dem Pufferausgang und/oder eine Einrichtung zur Erzeugung einer konstanten Referenzspannung zwischen dem Pufferausgang und dem Referenzanschluss und eine Einrichtung zur Strombeeinflussung des Leistungspfades vorgesehen.

Für letzteren Fall wird als Steuergröße das jeweils am Spannungsteiler abgegriffene Potential zur Beeinflussung der Spannung an dem Stromregelanschluss benützt.

Als Verstärkerelemente 102 sind auch P Kanal MOSFET Transistoren geeignet, die bei Serienschaltungen nach Stand der Technik wegen der höheren Zwischenelektrodenkapazitäten im Vergleich zu N Kanal MOSFET Transistoren nur sehr geringe Bandbreiten der gesamten Serienschaltung erreichten. Ansonsten sind auch NPN,PNP und IGBT Transistoren, selbstleitende depletion Feldeffekttransistoren beider Polaritäten und Röhren , z.B. Trioden als Verstärkerelement 102 in einem Hybrid-Verstärkerelement 100 einsetzbar.

Die Adaption der Entkoppeleinheit auf beispielsweise P Kanal MOSFET Transistoren ist mit dem bekannten Schnittstellenverhalten für den Fachmann leicht zu realisieren.

In einer vorteilhaften Ausführung ist als Einrichtung zur Beeinflussung des Stromes zwischen dem Stromregelanschluss und dem Referenzanschluss eine von der Spannung zwischen Puffereingang und Referenzanschluss gesteuerte Stromquelle geschaltet. Insbesondere ist hierzu in der Entkoppeleinheit zwischen dem Stromregelanschluss und dem Referenzanschluss ein weiteres Verstärkerelement mit seinem Leistungspfad geschaltet, dessen Steuereingang mit dem Puffereingang verbunden ist. Nach Art einer Gate-Schaltung werden somit der Steuereingang des Verstärkerelements durch das als Stromquelle wirkende weitere Verstärkerelement angetrieben. Dieser Steuereingang wird hierbei gegebenenfalls über eine geeignete Spannungsquelle gegenüber dem Bezugspotential auf einem festen Spannungswert gehalten. Das Hybrid-Verstärkerelement weist in der Entkoppeleinheit wenigstens einen Versorgungsanschluss zum Anlegen einer Betriebsspannung gegenüber dem Referenzausgang auf. Die Betriebsspannung wird hierbei beispielsweise durch eine floatende Spannungsquelle geliefert oder aus dem Leistungspfad der Verstärkerkette gewonnen.

In einer weiter bevorzugten Ausgestaltung ist der Puffereingang der Entkoppeleinheit als ein Elektrometereingang ausgebildet, der insofern eine gegen unendlich gehende Eingangsimpedanz aufweist.

Da die Stromrichtung am Steuereingang des Verstärkerelements wechseln kann, ist der Pufferausgang der Entkoppeleinheit zweckmäßigerweise derart ausgebildet, dass er bezüglich der Stromcomplianz bidirektional wirkt, also ebenso viel Strom aufnehmen wie abgeben kann. Ansonsten hat die slew rate der gesamten Serienschaltung für eine ansteigende Signalflanke einen verschiedenen Wert wie für eine fallende Signalflanke.

Zur Spannungsversorgung eines Versorgungsanschlusses der Entkoppeleinheit ist weiter bevorzugt ein Versorgungsanschluss der Entkoppeleinheit über einen hochohmigen Filterwiderstand mit einem Bezugspunkt im Leistungspfad des externen Verstärkerelements und in der Entkoppeleinheit mit dem Pufferausgang verbunden, wobei zwischen dem Pufferausgang und dem Referenzausgang ein Schaltungselement zur Spannungsstabilisierung und eine Kapazität parallel geschaltet sind. Diese Kapazität bildet mit dem hochohmigen Filterwiderstand einen Tiefpass mit sehr langer Zeitkonstante $\tau_{R_{filster}} C_{puffer} \geq 1s$. Der hochohmige Widerstand kann auch durch eine Konstantstromquelle ersetzt werden, was aber den Schaltungsaufwand erhöht. Wird der Versorgungsanschluss über den Widerstand entlang der Verstärkerkette bzw. im Leistungspfad des Verstärkerelements mit einem Bezugspunkt verbunden, der ein gegenüber dem Referenzanschluss geändertes Potential aufweist, so fließt ein kleiner Betriebsstrom über das Schaltungselement zur Spannungsstabilisierung. Die Versorgungsspannung wird insofern aus dem Leistungspfad der Verstärkerelemente gewonnen. Als Schaltelemente zur Spannungsstabilisierung können Leuchtdioden, Zenerdioden oder Referenzspannungsregler eingesetzt sein.

In einer weiteren vorteilhaften Ausgestaltung ist in der Entkoppeleinheit zwischen dem Puffereingang und dem Pufferausgang ein Open-Loop-Pufferverstärker eingeschaltet, wobei der Stromregelanschluss und der Referenzanschluss miteinander verbunden sind. Ein integrierter Open-Loop-Pufferverstärker zeichnet sich durch eine hohe Eingangsimpedanz, eine geringe Ausgangsimpedanz, eine große bidirektionale Stromkompliance und eine hohe Slew-Rate aus. In diesem Fall kann der Stromregelanschluss in der Entkoppeleinheit unmittelbar mit dem Referenzanschluss verbunden sein. Der Steuereingang des Verstärkerelements liegt dabei gegenüber dem Referenzausgang auf dem Potential des Ausgangs des Open-Loop-Pufferverstärkers.

Bevorzugt ist der Spannungsteiler aus wenigstens zwei passiven Bauteilen gebildet, zwischen denen der Puffereingang der Entkoppeleinheit angeschlossen. Die passiven Bauteile können beispielsweise Widerstände und/oder Kapazitäten sein.

Hinsichtlich der Schaltungsanordnung wird die Aufgabe erfindungsgemäß durch wenigstens zwei in Serie geschaltete vorbeschriebene Hybrid-Verstärkerelemente gelöst, wobei die jeweiligen Verstärkerelemente mit ihren Leistungspfaden in Serie geschaltet sind, und wobei die Puffereingänge der jeweiligen Entkoppeleinheiten mit einem Netzwerk zur Potentialteilung verbunden sind, welches die Spannungsteiler umfasst.

Die Erfindung betrachtet dabei die Serienschaltung von Verstärkerelementen topologisch als eine Ersatzschaltung (subcircuit) eines neuen Verstärkerelementes. Es wird hier als Ersatzverstärkerelement benannt, welches durch die angegebene Schaltungsanordnung von zwei in Serie geschalteten Hybrid-Verstärkerelementen und der diese treibenden untersten Stufe gebildet ist. Die unterste Stufe erhält an ihrem Steuereingang ein Eingangssignal und ist deshalb die Treiberstufe der seriell folgenden Hybrid-Verstärkerelemente. Dieses Ersatzverstärkerelement kann dann im Wesentlichen so, wie die Treiberstufe alleine, in beliebigen Schaltungen eingesetzt werden. Die Eigenschaften dieses neuen Verstärkerelementes sind außer der erhöhten Durchbruchspannung wenig schlechter als die der treibenden untersten Stufe ohne die "aufgesetzte" Serienschaltung der Hybrid-Verstärkerelemente, welche dem alleinigen Zweck der vorgegebenen Duplizierung des Spannungsabfalls über dem Leistungspfad der Treiberstufe dienen. Dies betrifft die Steilheit der Treiberstufe, deren Zwischenelektrodenkapazitäten, den parallel zu dem Leistungspfad der Treiberstufe liegenden ohmschen Wirkanteil und, wie gezeigt wurde, eine als Störstrominjektion bezeichnete, ebenfalls parallel zu dem Leistungspfad der Treiberstufe liegende nichtlineare Störstromquelle.

In einer bevorzugten Ausgestaltung ist das Netzwerk zur Potentialteilung als eine Spannungsteilerkette ausgebildet, wobei die Potentiale am Puffereingang jeder Entkoppeleinheit von einem zugeordneten Bezugspunkt entlang der Spannungsteilerkette abgegriffen sind.

Zum Abgriff eines Ausgangsspannungsignals ist in einer zweckmäßigen Weiterbildung ein ohmscher Widerstand in Serie zu den Leistungspfaden geschaltet.

Auf die angegebene Schaltungsanordnung können sinngemäß die für das Hybrid-Verstärkerelement genannten Vorteile übertragen werden.

Ausführungsbeispiele der Erfindung werden durch eine Zeichnung näher erläutert. Dabei zeigen:

Fig. 1    eine Serienschaltung von Verstärkerelementen gemäß Stand der Technik,
Fig. 2    eine Gate-Schaltung eines Transistors gemäß Stand der Technik,
Fig. 3    das Kleinsignalersatzschaltbild der Schaltung gemäß Fig. 2,
Fig. 4    das Kleinsignalersatzschaltbild der Schaltung gemäß Fig. 1,
Fig. 5    in einem Diagramm die Funktionsweise eines Hybrid- Verstärkerelements mit Entkoppeleinheit und Verstärkerelement,
Fig. 6    die Beschaltung einer Entkoppeleinheit gemäß eines ersten Ausfüh- rungsbeispiels,
Fig. 7    eine Verstärkerschaltung mit Entkoppeleinheiten gemäß Fig. 6,
Fig. 8    die Beschaltung einer Entkoppeleinheit gemäß eines weiteren Aus- führungsbeispiels,
Fig. 9    eine Verstärkerschaltung mit Entkoppeleinheiten gemäß Fig. 8,
Fig.10    die Spannungsaufteilung einer Serienschaltung nach dem Stand der Technik, ermittelt mit einer PSpice Simulation und
Fig.11    den Frequenzgang der Transimpedanz einer Serienschaltung nach dem Stand der Technik im Vergleich mit dem einer Serienschaltung nach der Erfindung, ermittelt mit einer PSpice Simulation.

Die Schaltbilder gemäß der Fig. 1 bis 4 stellen Stand der Technik dar und sind bereits in der Beschreibungseinleitung zur Erklärung des Ausgangspunktes der Erfindung beschrieben.

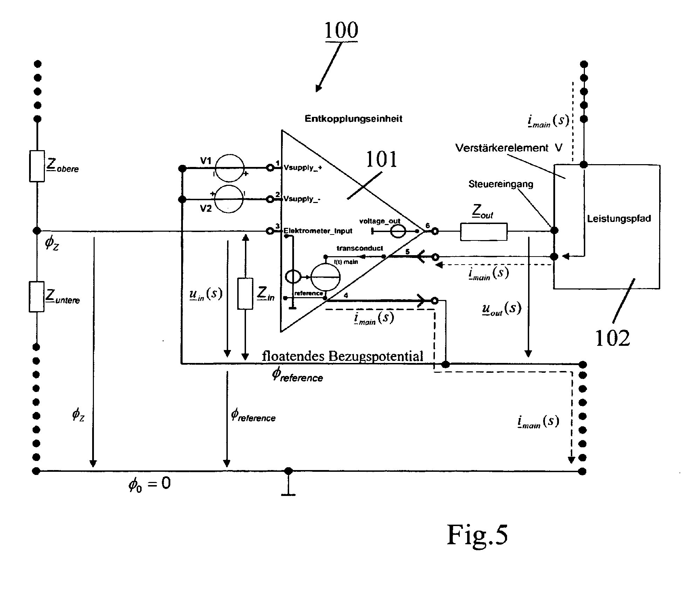

In Fig. 5 ist ein Hybrid-Verstärkerelement 100 mit einer Entkoppeleinheit 101 und einem Verstärkerelement 102 zur Erläuterung des Schnittstellenverhaltens dargestellt, wenn das Hybrid-Verstärkerelement 100 beispielsweise in eine bekannte Serienschaltung von Verstärkerelementen gemäß Fig. 1 eingefügt wird. Entscheidend für die Wirkung der Entkoppeleinheit 101 ist die geringe dynamische Ausgangsimpedanz $\underline{Z}_{our}$, welche zwischen dem Steuereingang jedes Verstärkerelements 102 und dem zugehörigen floatenden Bezugspotential $\phi_{reference}$ des Pufferausganges 4 liegt. $\underline{Z}_{out}$ ist in Fig. 5 zur Verdeutlichung ausserhalb der Entkopplungseinheit 101 gezeichnet (Thevenin Ersatz). Die Umladeströme der Zwischenelektrodenkapazitäten des Verstärkerelementes 102 können nicht über die Spannungsteiler $\underline{Z}_{umere}$, $\underline{Z}_{obere}$ fließen. Diese parasitären Ströme über die Zwischenelektrodenkapazitäten jedes Verstärkerelementes 102 werden mit der Entkoppeleinheit 101 von den Abgriffen des Spannungsteilers isoliert.

Die Entkoppeleinheit 101 weist einen ersten Versorgungsanschluss 1. Einen zweiten Versorgungsanschluss 2 , einen Puffereingang 3 oder Elektrometereingang, einen Referenzanschluss 4, einen Stromregelanschluss 5 sowie einen Pufferausgang 6 auf.

Zwischen dem Versorgungsanschluss 1,2 und dem Referenzanschluss 4 wird die zur Versorgung der Entkoppeleinheit 101 benötigte Betriebsgleichspannung angelegt. Hierfür sind im Allgemeinen zwei kleine floatende Netzteile vorgesehen. Der fließende Ruhestrom in den Zuleitungen zum Versorgungsanschluss 1,2 für die Versorgung der Entkoppeleinheit wird möglichst klein eingestellt. In einem später beschriebenen Ausführungsbeispiel der Entkoppeleinheit 101 wird eine Möglichkeit gezeigt, wie die Versorgungsspannung der Entkoppeleinheit 101 durch Tiefpassfilterung mit großer Zeitkonstante aus dem Ruhestrom im Leistungspfad abgeleitet werden kann, um den erheblichen Schaltungsaufwand und die nachteiligen Streukapazitäten floatendener, also galvanisch getrennter, Netzteile zu vermeiden. Für selbstleitende Feldeffekttransistoren als Verstärkerelemente 102 kann auf eine externe Betriebsspannungszuführung an den Versorgungsanschlüssen 1 und 2 ganz verzichtet werden.

Der Puffereingang 3 bildet den Eingang der Entkoppeleinheit 101. Für die Funktion entscheidend ist dabei eine möglichst große Eingangsimpedanz $\underline{Z}_{in}$ zwischen dem Puffereingang 3 und dem Referenzanschluss 4, ähnlich dem Eingang eines Elektrometerverstärkers. Im Idealfall gilt also :

$$\left| \underline{Z}_{in} \right| = \left| \underline{Z}_{3,4} \right| \to \infty \quad (1)$$

$$\Rightarrow \left| \underline{I}_{Pin3} \right| \to 0$$

Der ohmsche Widerstand zwischen dem Puffereingang 3 und dem Referenzanschluss 4 muss möglichst groß und die Kapazität zwischen dem Puffereingang 3 und dem Referenzanschluss 4 möglichst klein sein. Dies gilt natürlich auch für parasitäre aufbauabhängige Kapazitäten des Puffereinganges 3 zu anderen Teilen der Schaltung, z.B. der Hauptmasse $\phi_0$. Der Strom in den Puffereingang 3 wird dadurch sehr klein, um die Spannungsteiler $\underline{Z}_{untere}$, $\underline{Z}_{obere}$ nicht störend zu belasten.

Zwischen der Eingangsspannung $\underline{u}_{lm}(s) = \underline{u}_{3,4}(s)$ und der Ausgangsspannung am Pufferausgang 6 $\underline{u}_{out}(s) = \underline{u}_{6,4}(s)$ gilt folgende Übertragungsgleichung :

$$\underline{u}_{out}(s) = \underline{A} \bullet \underline{u}_{in}(s) \pm U_{ref} \quad (2)$$

mit

$$U_{V\,sup\,ply\_-} = U_{2,4} \leq U_{ref} \leq U_{1,4} = U_{V\,sup\,ply\_+}$$

$$\left| \underline{A} \right| \geq 0 \quad, U_{ref} = const \,, \, \left| \underline{A} \right| = const$$

Mit $\underline{A}$ wird die Spannungsverstärkung der Entkoppeleinheit beschrieben. $|\underline{A}|$ soll breitbandig bis zu einer Frequenz, die wesentlich , also vorzugsweise um den Faktor 10, über der oberen gewünschten Nutzungsfrequenz der gesamten Serienschaltung liegt, einen konstanten Wert (meistens 1) haben und deshalb nur eine kleine Phasendrehung $\varphi(u_{in}, u_{out})$ aufweisen. Abhängig von der Ausführung der Entkoppeleinheit kann es auch sinnvoll sein, die Spannungsverstärkung $\underline{A}$ auf Null zu setzen und eine konstante Gleichspannung $U_{ref}$ an den Pufferausgang 6 zu legen.

Der Pufferausgang 6 bildet einen Ausgang der Entkoppeleinheit 101 und wird mit der Steuerelektrode des Verstärkerelementes 102 verbunden. Bei Transistoren als Verstärkerelement 102 ist dies also entweder die Basis bei bipolaren Transistoren, oder das Gate bei Feldeffekttransistoren. Der komplexe Ausgangswiderstand $\underline{Z}_{out}$ ,der als Serienelement zwischen dem Pufferausgang 6 und dem Referenzanschluss 4 wirkt, soll dabei möglichst klein gehalten werden.

$$\left|\underline{Z}_{out}\right| = \left|\underline{Z}_{6,4}\right| \rightarrow 0 \quad (3)$$

Die Steuerelektroden der seriengeschalteten Verstärkerelemente werden deshalb niederohmig angesteuert. Der Pufferausgang 6 treibt die Ströme zur Umladung der Zwischenelektrodenkapazitäten mit der Ausgangsspannung $\underline{u}_{out}(s)$, ohne Rückwirkung auf das Potential der Spannungsteilerkette am Puffereingang 3 auszüüben. Da die Richtung der Ströme über die Zwischenelektrodenkapazitäten beim Aufladen entgegengesetzt zu der beim Entladen ist, muss der Ausganganschluss 6 bidirektional wirken, d.h. die Entkoppeleinheit kann vorzugsweise am Pufferausgang 6 gleichviel Strom aufnehmen wie abgeben.

Für eine Entkoppelwirkung gilt damit also:

$$\left|\frac{\underline{I}_{Pin6}}{\underline{I}_{Pin3}}\right| = \beta \gg 1 \quad (4)$$

Die Entkoppelwirkung wird mit steigender Stromverstärkung $\beta$ besser, ideal ist also $\beta \rightarrow \infty$.

Der Stromregelanschluss 5, die Funktion beschreibend mit <transconduct> im Schaltsymbol der Entkopplungseinheit 101 bezeichnet, ist mit dem Leistungspfad eines seriengeschalteten Verstärkerelementes 102 verbunden. Bei bipolaren Transistoren, also mit dem Emitter, bei Feldeffekttransistoren mit dem Source Anschluss. Abhängig von der Ausführung der Entkoppeleinheit 101 kann mit diesem Ausgang die Steilheit S des Verstärkerelementes 102 linearisiert und erhöht werden. Bei angeschlossenem Verstärkerelement 102 realisiert die Entkoppeleinheit 101 zwischen der Eingangsspannung $\underline{u}_{in}(s)$ und dem Strom $\underline{i}_{main}(s) = \underline{i}_{pms}(s)$ im Hauptstrompfad bzw. im Leistungspfad des Verstärkerelementes 102 ein Transkonduktanzverhalten:

$$i_{main}(s) = f(\underline{U}_{in}) = S_{wirk} \bullet \underline{u}_{in}(s)$$
$$S_{wirk} = \left|\underline{A}\right| \bullet S_{Verstärkerelement} + S_{Entkoppeleinheit} \quad (5)$$

Der Strom $\underline{i}_{main}(s)$ wird also durch den Potentialunterschied zwischen dem jeweiligen Abgriff der Spannungsteilerkette und dem floatenden Bezugspotential der Entkoppeleinheit mit $\underline{u}_{in}(s) = \phi_z - \phi_{reference}$ gesteuert. Die für die Eingangsspannung $\underline{u}_{in}(s)$ wirksame Steilheit $S_{wirk}$ des Hybrid- Verstärkerelementes 100 weist zwei Anteile auf :

Die Steiheit des Verstärkerelementes $S_{Verstärkerelement}$, also beispielsweise die Steilheit eines hochspannungsfesten MOSFET Transistors als Verstärkerelement 102, welche durch den Strom im Arbeitspunkt und die Eingangskennlinie des Transistors bestimmt wird. Da der Ruhestrom wegen der abzuführenden Verlustwärme im Bereich weniger $mA$ liegt, arbeitet der MOSFET Transistor im Bereich der "subthreshold region". $S_{Verstärkerelement}$ ist dort sehr klein , beispielsweise $10mS$. Eine Spannungsverstärkung $\left|\underline{A}(s)\right|$ der Entkopplungseinheit vergrößert dabei die Steilheit des Verstärkerelementes $S_{Verstärkerelement}$ direkt proportional auf $\left|\underline{A}(s)\right| \bullet S_{Verstärkerelement}$.

Im Vergleich zu einer Serienschaltung von Verstärkerelementen gemäß Stand der Technik kann in der Entkoppeleinheit 101 eine spannungsgesteuerte Stromquelle mit hochfrequenztauglichen Niederspannungsbauteilen, kleinen Zwischenelektro-denkapazitäten und damit hoher Bandbreite realisiert werden. Diese Stromquelle kann auch bei kleinem Ruhestrom eine vergleichsweise große Steilheit erreichen und ist dann die Steilheit der Entkopplungseinheit 101 $S_{Entkoppeleinheit}$.

Der Referenzanschluss 4 dient als Bezugspunkt für die anderen Anschlüsse der Entkoppeleinheit 101 und als Pfad für den Ausgangsstrom $\underline{i}_{main}(s)$.

Das Schnittstellenverhalten der Entkopplungseinheit 101 lässt sich folgendermassen zusammenfassen: Jeder Anschluss ist auf das floatende Bezugspotential $\phi_{reference}$ (Pin 4) bezogen. $U_{V1}, U_{V2}$ ist die Betriebsspannung der Entkopplungseinheit (Pin1, 2).

Floatendes Bezugspotential (Pin 4): $\underline{u}_{in}(s) = \phi_z - \phi_{reference}$

Transkonduktanzverhalten (Pin 5): $\underline{i}_{main}(s) = S_{wirk} \bullet \underline{u}_{in}(s)$

(fortgesetzt)

$$S_{wirk} = |\underline{A}| \cdot S_{Verstär\,ker\,element} + S_{Entkopplungseinheit}$$

Elektrometereingang (Pin 3):     $|\underline{Z}_{in}| \to \infty$

Spannungsausgang (Pin 6):     $|\underline{Z}_{out}| \to 0$

$$\underline{u}_{out}(s) = \underline{A}(s) \cdot \underline{u}_{in}(s) \pm U_{ref}$$

Übertragungsfunktion:     $|\underline{A}| \geq 0,\ |\underline{A}| = const$

$$U_{V2} \leq U_{ref} \leq U_{V1},\ U_{ref} = const$$

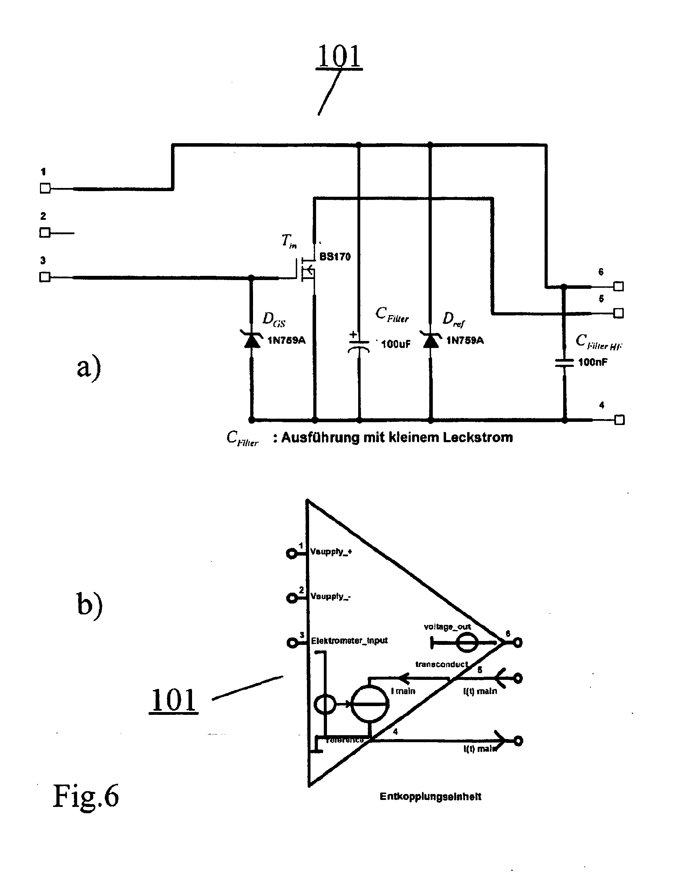

Fig. 6 zeigt die Beschaltung einer Entkoppeleinheit 101 gemäß einem ersten Ausführungsbeispiel. Fig. 6a) zeigt dabei die innere Beschaltung. Fig. 6b) zeigt die hierzu entsprechende Schaltsymbolik. Eine Besonderheit hier ist die Erzeugung der Versorgungsspannung am Versorgungsanschluss 1 der Entkoppeleinheit 101 aus der Betriebsspannung der Verstärkerelemente, um den Schaltungsaufwand für floatende Netzteile zu vermeiden.

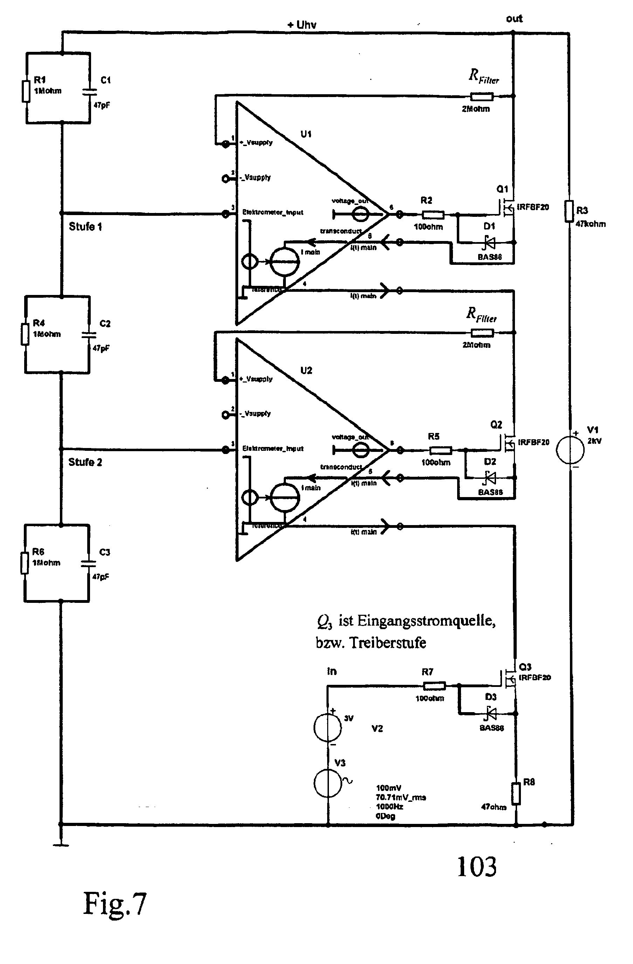

Wie in Fig. 7 dargestellt, wird der Versorgungsanschluss 1 dabei jeweils mit einem Schaltungspunkt verbunden, der auf sehr viel positiverem Potential als der Referenzanschluss 4 liegt. Der Widerstand $R_{Filter}$ kann auch außerhalb der Entkoppel-einheit 101 angeordnet sein. Der Pufferausgang 6 ist mit dem Versorgungsanschluss 1 verbunden. Innerhalb der Entkoppeleinheit 101 beginnt ein kleiner Gleichstrom über den Widerstand $R_{Filter}$, vorliegend 2 M$\Omega$, im $\mu A$ -Bereich zum Referenzanschluss 4 zu fließen. Die Zenerdiode $D_{ref}$ bewirkt auch bei diesen kleinen Strömen eine ausreichend stabile Referenzspannung von etwa 12V; diese Spannung wird mit dem Kondensator $C_{Filter}$ gepuffert und das Rauschen der Zenerdiode verringert. Der aus dem Widerstand $R_{Filter}$ und dem Kondensator $C_{Filter}$ gebildete Tiefpass hält Signalfrequenzen vom Pufferausgang 6 fern und belastet den Rest der Schaltung nur gering mit dem hochohmigen Widerstand $R_{Filter}$.

Die Kapazität $C_{Filterr}$ sorgt für eine geringe dynamische Ausgangsimpedanz $\underline{Z}_{out}$ bei Signalfrequenzen. Der Gleichstrom durch den Widerstand $R_{Filter}$, also $I_{R_{Filter}}$ ist wesentlich größer als der Leckstrom in das Gate des Verstärkerelementes am Pufferausgang 6. Da die Eingangsspannung $\underline{u}_{in}(s)$ hier am Pufferausgang 6 nicht erscheint, ist der Spannungsverstärkungsfaktor $\underline{A}(s)=0$. Gleichung (2) wird :

$$\underline{u}_{out}(s) = \pm U_{ref} = 12V \;(2)$$

Gleichung (5) wird mit $\underline{A}(s) = 0$ zu:

$$\underline{i}_{main}(s) = f(\underline{U}_{in}) = S_{wirk} \bullet \underline{u}_{in}(s)$$

$$S_{wirk} = S_{Entkoppeleinheit} = S_{T_1}$$

Der Transistor $T_1$ bewirkt mit seiner Steilheit $S_{T1}$ das Transkonduktanzverhalten $\underline{i}_{main}(S) = S_{T1} \bullet \underline{u}_{in}(s)$ und weist nur sehr kleine Zwischenelektrodenkapazitäten mit geringem Spannungshub unterhalb $U_{ref}$ und deshalb kleinen Steuerelektrodenströmen auf. Der verwendete Standardtransistor BS 170 weist etwa 10% der Zwischenelektrodenkapazitäten des hochspannungsfesten IRFBF 20 auf. Wird die Betriebsspannung der gesamten Schaltung, hier 2kV, angelegt, werden die Pufferkondensatoren $C_{Filter}$ in den Entkopplungseinrichtungen $U_1$ und $U_2$ gleichzeitig aufgeladen, weil sie elektrisch in Serie geschaltet sind. Dies funktioniert bei beliebig vielen seriengeschalteten Hybrid- Verstärkerelementen in gleicher vorteilhafter Weise.

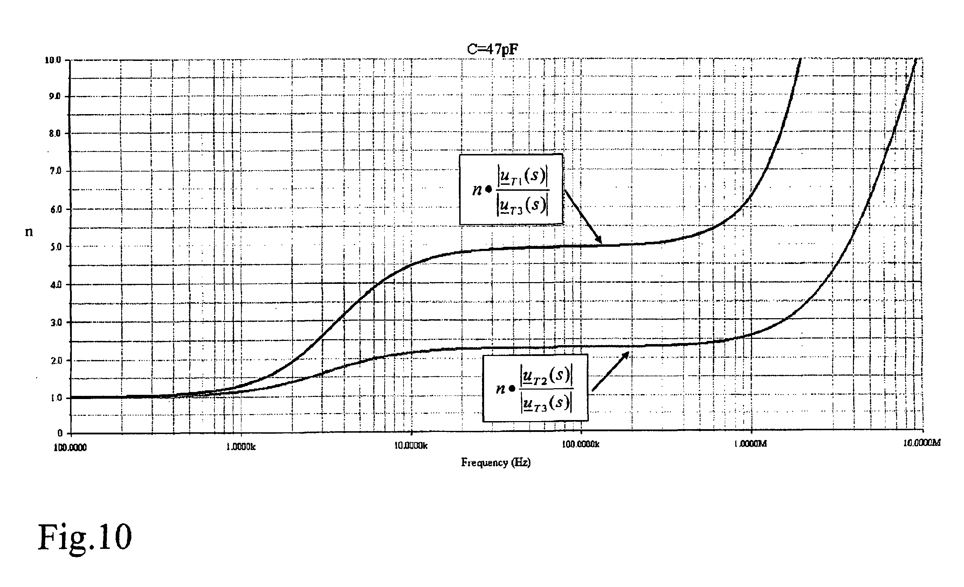

Fig.10 zeigt die Simulation der wichtigen Spannungsverteilung, $\dfrac{|\underline{u}_{T1}(s)|}{|\underline{u}_{T3}(s)|}$ und $\dfrac{|\underline{u}_{T2}(s)|}{|\underline{u}_{T3}(s)|}$ einer Serienschaltung nach Stand der Technik gemäß Fig. 4 bzw. Fig 1 über der Frequenz des Eingangsstromes $\underline{i}_e(s)$. An der Abzisse in Fig. 10 ist der Faktor n dargestellt, um den sich $\underline{u}_{T1}(s)$, $\underline{u}_{T2}$ von $\underline{u}_{T3}(s)$ im Betrag unterscheiden. Für eine gleichmäßige Spannungsaufteilung ist $n=1$.

Die Simulation erfolgte für die Schaltung aus Fig. 4 mit den Zwischenelektrodenkapazitäten für $T_{1,2,3}$ des MOSFET Transistors IRFBF20 und einer gemessenen Steilheit $S = 10mS$. Für $\underline{Z}_{1,2,3}$ wurden je 1M$\Omega$| |47pF wie in Fig.

7 gewählt. Die Spannung über der Eingangsstromquelle $|\underline{u}_{T1}(s)|$ liegt ab f $\approx$ 10kHz bereits um den Faktor $n \approx 5$ über $|\underline{u}_{T3}(s)|$, also dem Transistor mit der kleinsten Spannung. Dieses Verhalten wurde in der Einleitung ausführlich beschrieben. Für eine gleichmäßige Spannungsaufteilung muss $C = 1nF$ gewählt werden.

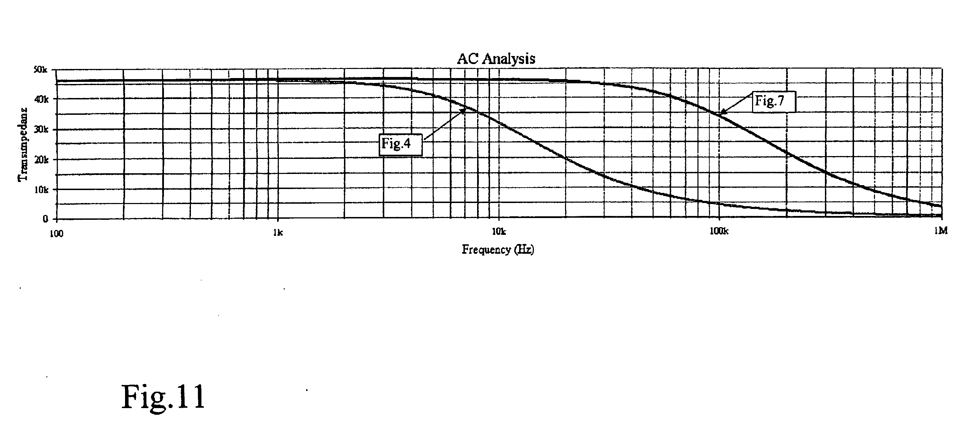

In Fig.7 genügt $C_{1,2,3} = 47pF$, um eine gleichmäßige Spannungsverteilung zu erreichen. Fig.11 zeigt schließlich die Simulation für den Frequenzgang der Transimpedanz $\underline{Z}_T(s) = \dfrac{\underline{u}_a(s)}{\underline{i}_e(s)}$ Fig.4 mit $\underline{Z}_{1,2,3} = 1M\Omega \| 1nF$ und mit den Zwischenelektrodenkapazitäten und der Steilheit des MOSFET Transistors IRFBF20 und ansonsten identischen Bauteilewerten wie in Fig.7 . Ideal für die Transimpedanz $\underline{Z}_T(s) = \dfrac{\underline{u}_a(s)}{\underline{i}_e(s)}$ hier der Wert von $R_D = 47k\Omega$ Der Frequenzgang der Transimpedanz der Schaltung aus Fig.7 ist zum Vergleich ebenfalls simuliert. Wie zu erkennen ist, erhöht die Serienschaltung mit den Hybrid-Verstärkerelementen des Ausführungsbeispiels aus Fig.7 die Grenzfrequenz $\omega_{-3dB}$ etwa um den Faktor 10. Dieses Ergebnis wurde in guter Übereinstimmung auch in der Praxis erreicht.

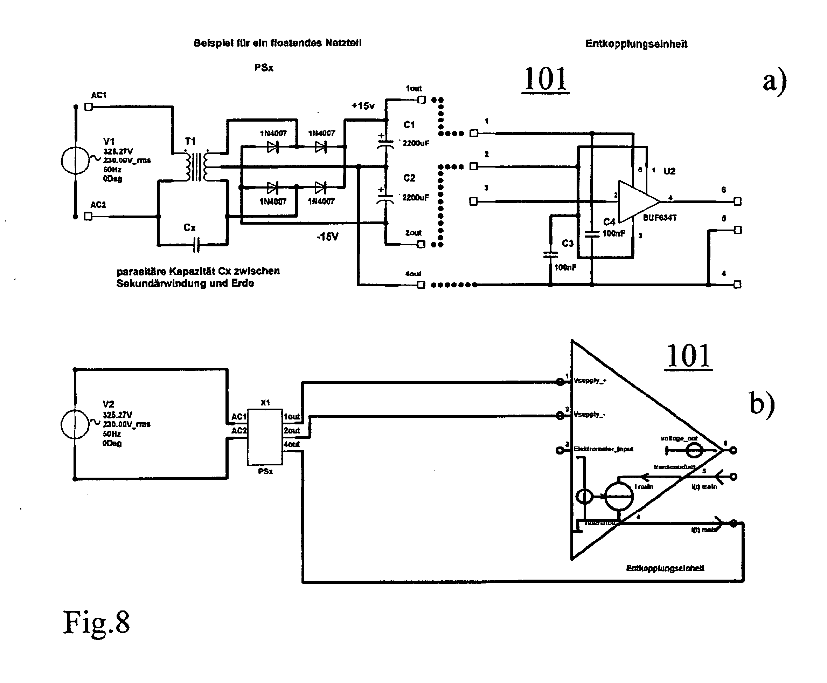

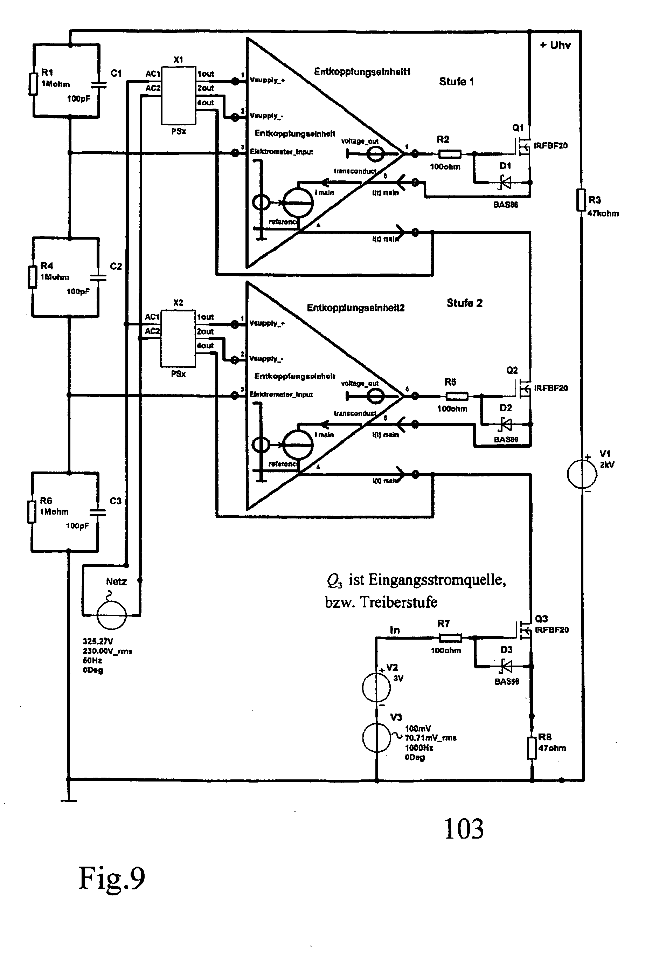

In Fig. 8 ist ein weiteres Ausführungsbeispiel zur Beschaltung einer Entkoppeleinheit 101 dargestellt. Fig. 8a) zeigt hierfür die interne Beschaltung. Fig. 8b) zeigt die entsprechende Symbolik. In Fig. 9 ist die entsprechende Verstärkerschaltung 103 mit Hybrid Verstärkerelementen 100 dargestellt. Gemäß Fig. 8a) ist die interne Beschaltung der Entkoppeleinheit 101 über einen integrierten Open- Loop- Pufferverstärker BUF 634T (Texas Instruments) realisiert. Dieser zeichnet sich durch eine hohe Eingangsimpedanz von $\underline{Z}_{in} = \underline{Z}_{3,4} \approx 80M\Omega \| 10pF$, einen geringen Ausgangswiderstand $\underline{Z}_{out} = \underline{Z}_{6,4} \leq 20\Omega$, eine große bidirektionale Stromkompliance $I_{out} \approx \pm 250mA$ und eine hohe slew rate von 2000V/μs aus. Die Spannungsverstärkung $|\underline{A}| \approx 1$. Durch die Open- Loop- Ausführung eignet sich der Pufferverstärker BUF 634T besonders für kapazitive Lasten, da wegen einer fehlenden Gegenkopplungsschleife zwischen Ausgang und Eingang keine Oszillationen auftreten können. Ähnliche Pufferverstärker werden auch von anderen Herstellern angeboten. Die Gleichspannung am Ausgang beträgt einige $mV$ und lässt sich vernachlässigen.

Damit wird die Gleichung (2) mit $|\underline{A}| = 1$ :

$$\underline{u}_{out}(s) \approx \underline{u}_{in}(s)$$

Die Gleichung (5) wird mit $\underline{A}(s) = 1 \wedge S_{Entkopplungseinheit} = 0$ zu :

$$\underline{i}_{main}(s) = f(\underline{U}_{in}) = S_{wirk} \bullet \underline{u}_{in}(s)$$

$$S_{wirk} = |\underline{A}| \bullet S_{Verstärkerelement} = S_{Q_{1,2}} = S_{IRFBF20}$$

Die Verstärkerelemente $Q_{1,2}$ (siehe Fig. 9) alleine bewirken also das Transkonduktanzverhalten $\underline{i}_{main}(s) = S_{IRFBF20} \bullet \underline{u}_{in}(s)$ der Entkoppeleinheiten $U_{1,2}$. Wegen des erforderlichen Ruhestromes von $I_Q \approx \pm 15mA$ des Pufferverstärkers BUF 634T ist hier die Erzeugung der Betriebsspannung der Entkoppeleinheit 101 aus der Betriebsspannung der seriengeschalteten Verstärkerelemente mit hohen Wärmeverlusten in den Vorspannungswiderständen $R_{Filter}$ verbunden und hätte auch einen größeren Ruhestrom als $I_Q$ im Hauptstrompfad zur Voraussetzung. Deshalb müssen kleine floatende Netzteile, wie sie in Fig. 8a) gezeigt sind, eingesetzt werden. Die Kapazität $C_x$ zwischen der Primär- und Sekundärwicklung der für die Potentialtrennung erforderlichen Transformatoren sollte möglichst klein sein, da sie Ströme gegen Erde verursachen, welche wiederum die Spannungsteilerkette belasten. Hierfür ist beispielsweise eine Zweikammerwicklung möglich, die auch gleichzeitig die zulässige Potentialdifferenz zwischen Primär- und Sekundärwicklung erhöht.

Als Alternative können auch durchschlagfeste DC/DC Wandler benutzt werden. Diese Ausführung bietet den Vorteil, dass sich außer den seriengeschalteten Verstärkerelementen in einer Verstärkerschaltung 103 gemäß Fig. 9 keine weiteren wärmeerzeugenden Elemente im Hauptstromkreis befinden. Wegen des Aufwandes der floatenden Netzteile ist diese Variante besonders für wenige seriengeschaltete Verstärkerelemente und dafür große Ströme im Hauptstrompfad geeignet.

**Patentansprüche**

1. Hybrid-Verstärkerelement (100) mit einem Verstärkerelement (102), umfassend einen Steuereingang und einen Leistungspfad, mit einer Entkoppeleinheit (101), die einen Puffereingang (3), einen Pufferausgang (6), einen Referenzanschluss (4) und einen Stromregelanschluss (5) umfasst, und mit einem am Puffereingang (3) angeschlossenen Spannungsteiler (Z), der parallel zum Leistungspfad geschaltet ist, wobei der Pufferausgang (6) an den Steuereingang des Verstärkerelements (102) geschaltet und der Leistungspfad des Verstärkerelements (102) über den Stromregelanschluss (5) und den Referenzanschluss (4) geführt ist, wobei der Referenzanschluss (4) für die weiteren Anschlüsse ein Bezugspotential bildet, wobei der Puffereingang (3) gegenüber dem Referenzanschluss (4) eine hochohmige Eingangsimpedanz aufweist, wobei der Pufferausgang (6) gegenüber dem Referenzanschluss (4) eine niederohmige Ausgangsimpedanz aufweist, wobei eine Einrichtung zur linearen Spannungsverstärkung zwischen dem Puffereingang (3) und dem Pufferausgang (6) oder eine Einrichtung zur Erzeugung einer konstanten Referenzspannung zwischen dem Pufferausgang (6) und dem Referenzanschluss (4) in Kombination mit einer zwischen dem Stromregelanschluss (5) und dem Referenzanschluss (4) angeordneten Einrichtung zur Strombeeinflussung des Leistungspfades in Abhängigkeit des Potentialunterschiedes zwischen dem Puffereingang (3) und dem Referenzanschl uss (4) vorgesehen ist.

2. Hybrid-Verstärkerelement (100) nach Anspruch 1, wobei zwischen den Stromregelanschluss (5) und den Referenzanschluss (4) eine von der Spannung zwischen Puffereingang (3) und Referenzanschluss (4) gesteuerte Stromquelle geschaltet ist.

3. Hybrid-Verstärkerelement (100) nach Anspruch 1 oder 2,
wobei an der Entkoppeleinheit (101) wenigstens ein Versorgungsanschluss (1,2) zum Anlegen einer Betriebsspannung gegenüber dem Referenzausgang (4) vorgesehen ist.

4. Hybrid-Verstärkerelement (100) nach einem der vorhergehenden Ansprüche,
wobei der Puffereingang (3) der Entkoppeleinheit (101) als ein Elektrometereingang ausgebildet ist.

5. Hybrid-Verstärkerelement (100) nach einem der vorhergehenden Ansprüche,
wobei der Pufferausgang (6) der Entkoppeleinheit (101) bezüglich der Stromrichtung bidirektional wirkt.

6. Hybrid-Verstärkerelement (100) nach einem der vorhergehenden Ansprüche,
wobei in der Entkoppeleinheit (101) zwischen dem Stromregelanschluss (5) und dem Referenzanschluss (4) ein weiteres Verstärkerelement mit seinem Leistungspfad geschaltet ist, dessen Steuereingang mit dem Puffereingang (3) verbunden ist.

7. Hybrid-Verstärkerelement (100) nach Anspruch 3 und 6,
wobei wenigstens ein Versorgungsanschluss (1,2) der Entkoppeleinheit (101) über einen hochohmigen Widerstand oder über eine Konstantstromquelle mit einem Bezugspunkt im Leistungspfad des externen Verstärkerelements und in der Entkoppeleinheit (101) mit dem Pufferausgang (6) verbunden ist, und wobei zwischen dem Pufferausgang (6) und dem Referenzausgang (4) ein Schaltungselement zur Spannungsstabilisierung und eine Kapazität parallel geschaltet sind.

8. Hybrid-Verstärkerelement (100) nach einem der vorhergehenden Ansprüche,
wobei in der Entkoppeleinheit (101) zwischen dem Puffereingang (3) und dem Pufferausgang (6) ein Open-Loop-Puffenrerstärker (BUF) eingeschaltet ist, und wobei der Stromregelanschluss (5) und der Referenzanschluss (4) miteinander verbunden sind.

9. Hybrid-Verstärkerelement (100) nach einem der Ansprüche 3 bis 8,
wobei an den oder jeden Versorgungsanschluss (1,2) und das Bezugspotential des Referenzausgangs (4) eine floatende Spannungsversorgung angeschlossen ist.

10. Hybrid-Verstärkerelement (100) nach einem der vorhergehenden Ansprüche,
wobei der Spannungsteiler (Z) aus wenigstens zwei passiven Bauteilen gebildet ist, zwischen denen der Puffereingang (3) der Entkoppeleinheit (101) angeschlossen ist.

11. Schaltungsanordnung (103) mit wenigstens zwei in Serie geschalteten Hybrid-Verstärkerelementen (100) nach einem der vorhergehenden Ansprüche, wobei die jeweiligen Verstärkerelemente (102) mit ihren Leistungspfaden in Serie geschaltet sind, und wobei die Puffereingänge (3) der jeweiligen Entkoppeleinheiten (101) mit einem Netzwerk zur Potentialteilung verbunden sind, welches die Spannungsteiler (Z) umfasst.

12. Schaltungsanordnung (103) nach Anspruch 11,
wobei ein zusätzliches Verstärkerelement (Q3) mit seinem Leistungspfad in Serie zu den Leistungspfaden der Verstärkerelemente (102) des Hybrid-Verstärkerelements (100) geschaltet ist, an dessen Steuereingang ein Eingangssignal anliegt.

13. Schaltungsanordnung (103) nach Anspruch 11 oder 12,
wobei das Netzwerk zur Potentialteilung als eine Spannungsteilerkette ausgebildet ist, und wobei die Spannungen am Puffereingang (3) der jeweiligen Entkoppeleinheiten (101) jeweils von einem zugeordneten Bezugspunkt entlang der Spannungsteilerkette abgegriffen sind.

14. Verstärkerschaltung (103) nach einem der Ansprüche 11 bis 13,
wobei zum Abgriff eines Ausgangsspannungsignals ein ohmscher Widerstand in Serie zu den Leistungspfaden geschaltet ist.

**Claims**

1. Hybrid amplifier element (100) having an amplifier element (102), comprising a control input and a power path, having a decoupling unit (101) which comprises a buffer input (3), a buffer output (6), a reference terminal (4) and a current regulation terminal (5), and having a voltage divider (Z) connected to the buffer input (3) and in parallel with the power path, wherein the buffer output (6) is connected to the control input of the amplifier element (102) and the power path of the amplifier element (102) is routed via the current regulation terminal (5) and the reference terminal (4), wherein the reference terminal (4) forms a reference potential for the additional terminals, wherein the buffer input (3) has a high-resistance input impedance compared with the reference terminal (4), wherein the buffer output (6) has a low-resistance output impedance compared with the reference terminal (4), wherein a means for linear voltage amplification is provided between the buffer input (3) and the buffer output (6) or a means for producing a constant reference voltage is provided between the buffer output (6) and the reference terminal (4) in combination with a means, arranged between the current regulation terminal (5) and the reference terminal (4), for influencing the current in the power path depending on the potential difference between the buffer input (3) and the reference terminal (4).

2. Hybrid amplifier element (100) according to Claim 1,
wherein a current source which is controlled by the voltage between buffer input (3) and reference terminal (4) is connected between the current regulation terminal (5) and the reference terminal (4).

3. Hybrid amplifier element (100) according to either of claims 1 and 2,
wherein at the decoupling unit (101) at least one supply terminal (1, 2) is provided for applying an operating voltage relative to the reference output (4).

4. Hybrid amplifier element (100) according to one of the preceding claims,
wherein the buffer input (3) of the decoupling unit (101) is embodied as an electrometer input.

5. Hybrid amplifier element (100) according to one of the preceding claims,
wherein the buffer output (6) of the decoupling unit (101) has a bidirectional action in relation to the direction of current.

6. Hybrid amplifier element (100) according to one of the preceding claims,
wherein an additional amplifier element is connected by means of the power path thereof in the decoupling unit (101) between the current regulation terminal (5) and the reference terminal (4, the control input of said additional amplifier element being connected to the buffer input (3).

7. Hybrid amplifier element (100) according to Claims 3 and 6,
wherein at least one supply terminal (1, 2) of the decoupling unit (101) is connected to a reference point in the power path of the external amplifier element via a high-value resistor or via a constant-current source and is connected to the buffer output (6) in the decoupling unit (101), and wherein a circuit element for stabilizing the voltage and a capacitance are connected in parallel between the buffer output (6) and the reference output (4).

8. Hybrid amplifier element (100) according to one of the preceding claims,
wherein an open-loop buffer amplifier (BUF) is connected in the decoupling unit (101) between the buffer input (3) and the buffer output (6), and wherein the current regulation terminal (5) and the reference terminal (4) are connected to one another.

9. Hybrid amplifier element (100) according to one of Claims 3 to 8,
wherein a floating voltage supply is connected to the or each supply terminal (1, 2) and the reference potential of the reference output (4).

10. Hybrid amplifier element (100) according to one of the preceding claims,
wherein the voltage divider (Z) is formed from at least two passive components, between which the buffer input (3) of the decoupling unit (101) is connected.

11. Circuit arrangement (103) having at least two series-connected hybrid amplifier elements (100) according to one of the preceding claims,
wherein the respective amplifier elements (102) are connected in series by means of the power paths thereof, and wherein the buffer inputs (3) of the respective decoupling units (101) are connected to a potential divider network which comprises the voltage dividers (Z).

12. Circuit arrangement (103) according to Claim 11,
wherein an additional amplifier element (Q3) is connected in series, by means of the power path thereof, with the power paths of the amplifier elements (102) of the hybrid amplifier element (100), an input signal being present at the control input of said additional amplifier element.

13. Circuit arrangement (103) according to either of Claims 11 and 12,
wherein the potential divider network is formed as a voltage divider chain, and wherein the voltages at the buffer input (3) of the respective decoupling units (101) are in each case tapped off from an associated reference point along the voltage divider chain.

14. Amplifier circuit (103) according to one of Claims 11 to 13,
wherein an ohmic resistor is connected in series with the power paths in order to tap off an output voltage signal.


## Revendications

1. Elément amplificateur hybride (100) comportant un élément amplificateur (102) comprenant une entrée de commande et un trajet de puissance, comportant une unité de découplage (101) qui comprend une entrée tampon (3), une sortie tampon (6), une borne de référence (4) et une borne de commande de courant (5), et comportant un diviseur de tension (Z) relié à l'entrée tampon (3), qui est connecté en parallèle au trajet de puissance, dans lequel la sortie tampon (6) est connectée à l'entrée de commande de l'élément amplificateur (102) et le trajet de puissance de l'élément amplificateur (102) est amené à passer par la borne de commande de courant (5) et la borne de référence (4), dans lequel la borne de référence (4) forme un potentiel de référence pour les autres bornes, dans lequel l'entrée tampon (3) présente par rapport à la borne de référence (4) une impédance d'entrée de forte valeur, dans lequel la sortie tampon (6) présente par rapport à la borne de référence (4) une impédance de sortie de faible valeur, dans lequel il est prévu un dispositif destiné à amplifier linéairement la tension entre l'entrée tampon (3) et la sortie tampon (6) ou un dispositif destiné à générer une tension de référence constante entre la sortie tampon (6) et la borne de référence (4) en association avec un dispositif disposé entre la borne de commande de courant (5) et la borne de référence (4) pour réguler le courant du trajet de puissance en fonction de la différence de potentiel entre l'entrée tampon (3) et la borne de référence (4).

2. Elément amplificateur hybride (100) selon la revendication 1, dans lequel une source de courant commandée par la tension entre l'entrée tampon (3) et la borne de référence (4) est connectée entre la borne de commande de courant (5) et la borne de référence (4).

3. Elément amplificateur hybride (100) selon la revendication 1 ou 2, dans lequel au moins une borne d'alimentation (1, 2) est prévue sur l'unité de découplage (101) pour appliquer une tension de fonctionnement à la sortie de référence (4).

**4.** Elément amplificateur hybride (100) selon l'une quelconque des revendications précédentes, dans lequel l'entrée tampon (3) de l'unité de découplage (101) est réalisée sous la forme d'une entrée d'électromètre.

**5.** Elément amplificateur hybride (100) selon l'une quelconque des revendications précédentes, dans lequel la sortie tampon (6) de l'unité de découplage (101) fonctionne de manière bidirectionnelle en ce qui concerne la direction du courant.

**6.** Elément amplificateur hybride (100) selon l'une quelconque des revendications précédentes, dans lequel un élément amplificateur supplémentaire avec son trajet de puissance et dont l'entrée de commande est reliée à l'entrée tampon (3), est connecté dans l'unité de découplage (101) entre la borne de commande de courant (5) et la borne de référence (4).

**7.** Elément amplificateur hybride (100) selon les revendications 3 et 6, dans lequel au moins une borne d'alimentation (1, 2) de l'unité de découplage (101) est reliée par l'intermédiaire d'une résistance de forte valeur ou par l'intermédiaire d'un source de courant constant à un point de référence dans le trajet de puissance de l'élément amplificateur externe et à la sortie tampon (6) dans l'unité de découplage (101), et dans lequel un élément de circuit destiné à stabiliser la tension et une capacité sont connectés en parallèle entre la sortie tampon (6) et la sortie de référence (4).

**8.** Elément amplificateur hybride (100) selon l'une quelconque des revendications précédentes, dans lequel un amplificateur tampon en boucle ouverte (BUF) est connecté dans l'unité de découplage (101) entre l'entrée tampon (3) et la sortie tampon (6), et dans lequel la borne de commande de courant (5) et la borne de référence (4) sont reliées l'une à l'autre.

**9.** Elément amplificateur hybride (100) selon l'une quelconque des revendications 3 à 8, dans lequel une alimentation de tension flottante est raccordée à la ou à chaque borne d'alimentation (1, 2) et au potentiel de la sortie de référence (4).

**10.** Elément amplificateur hybride (100) selon l'une quelconque des revendications précédentes, dans lequel le diviseur de tension (Z) est constitué d'au moins deux composants passifs entre lesquels est connectée la sortie tampon (3) de l'unité de découplage (101).

**11.** Dispositif de circuit (103) comportant au moins deux éléments amplificateurs hybrides connectés en série (100) selon l'une quelconque des revendications précédentes, dans lequel les éléments amplificateurs respectifs (102) sont connectés en série à leurs trajets de puissance, et dans lequel les entrées tampons (3) des unités de découplage respectives (101) sont reliées à un réseau de distribution de courant qui comprend les diviseurs de tension (Z).

**12.** Dispositif de circuit (103) selon la revendication 11, dans lequel un élément amplificateur supplémentaire (Q3) à l'entrée de commande duquel est appliqué un signal d'entrée est connecté par son trajet de puissance en série avec les trajets de puissance des éléments amplificateurs (102) de l'élément amplificateur hybride (100).

**13.** Dispositif de commutation (103) selon la revendication 11 ou 12, dans lequel le réseau de distribution de courant est réalisé sous la forme d'une chaîne de diviseurs de tension et dans lequel les tensions sont respectivement prélevées par un point de référence associé le long de la chaîne de diviseurs de tension à l'entrée tampon (3) des unités de découplage (101) respectives.

**14.** Circuit d'amplification (103) selon l'une quelconque des revendications 11 à 13, dans lequel une résistance ohmique est connectée en série aux trajets de puissance pour prélever un signal de tension de sortie.

Fig. 1

Fig. 2

Fig.3

Fig.4

Fig.5

<u>101</u>

$T_{in}$ BS170

$D_{GS}$ 1N759A

$C_{Filter}$ 100uF

$D_{ref}$ 1N759A

$C_{Filter\ HF}$ 100nF

a)

$C_{Filter}$ : Ausführung mit kleinem Leckstrom

b)

<u>101</u>

1 Vsupply_+

2 Vsupply_-

3 Elektrometer_input

voltage_out

transconduct

I main

I(t) main

reference

I(t) main

Entkopplungseinheit

**Fig.6**

Fig.7

103

Fig.8

$Q_3$ ist Eingangsstromquelle, bzw. Treiberstufe

103

Fig.9

Fig.10

Fig.11

23

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19600593 C1
- US 8702622 W
- DE 10114935 A1

**In der Beschreibung aufgeführte Nicht-Patentliteratur**

- **P. HORROWITZ ; W. HILL.** Die hohe Schule der Elektronik. Elektorverlag, 2001
- **U.TIETZE ; CH. SCHENK.** Halbleiterschaltungstechnik. Springer Verlag, 2002, 268 ff
- **P. HOROWITZ ; W. HILL.** Die hohe Schule der Elektronik. Elektor Verlag, 2001, 417